# EUROPEAN PATENT APPLICATION

(11) **EP 2 319 815 A1**
(43) Date of publication of application: **11.05.2011**
(21) Application number: 09805070.1
(22) Date of filing: 07.08.2009
(51) Int. Cl.: C03C 27/12, B65G 49/06, C03B 35/20, H01L 21/683

(54) **BOARD HOLDING DEVICE, BOARD HOLDING METHOD, AND METHOD OF MANUFACTURING LAMINATED GLASS**

(30) Priority: 08.08.2008 JP 2008206124
(71) Applicant: Asahi Glass Company, Limited, Tokyo 100-8405 (JP)
(72) Inventor: ITO, Yasunori, Tokyo 100-8405 (JP)
(74) Representative: Müller-Boré & Partner Patentanwälte
(86) International application number: PCT/JP2009/064056
(87) International publication number: WO 2010/016588

(57) **Abstract**

By employing a simple structure, there is provided a device for holding a substrate, a process for holding a substrate, and a process for manufacturing laminated glass, which are capable of determining the position of a substrate to be held with good precision, ensuring a force enough to attract a substrate and preventing a substrate from coming off.

A device for holding a substrate 10, which is adapted to substantially horizontally hold a substrate and vertically move the substrate, is **characterized** to include a support 2; at least one substrate attraction member 1 supported by the support 2 and configured to attract the substrate; and a plurality of strip-shaped elastic members 4, which couple an outer peripheral portion of the at least one substrate attraction member 1 to regions of the support 2 apart from the outer peripheral portion of the at least one substrate attraction member 1 in a horizontal direction; wherein each of the strip-shaped elastic members 4 includes a deformable portion, which is formed as a strip-shaped member disposed between one end portion for coupling to the at least one substrate attraction member 1 and the other end portion for coupling to the support 2 and having a wide width in a horizontal direction and a thin thickness in a vertical direction, and which allows the at least one substrate attraction member 1 to relatively move closer to and apart from the support 2 in the vertical direction and is deformable in the horizontal direction.

## Description

### TECHNICAL FIELD

The present invention relates to a device for holding a substrate, a process for holding a substrate, and a process for manufacturing laminated glass, which are adapted to manufacture laminated glass or the like.

### BACKGROUND ART

Heretofore, laminated glass has been known, which is manufactured by laminating a pair of glass substrates (substrates) with a thermoplastic transparent resin film of, e.g. polyvinyl butyral (PVB) or a thermal-crosslinkable transparent resin film interposed therebetween while the substrates are heated and pressed in an autoclave. Such laminated glass has been employed as the windshield of an automobile since fragments of broken glass adhere to the film so as to be prevented from scattering. Laminated glass has also been employed as window glass (safety glass or security glazing) of a building because of being hard to be pierced therethrough and having an excellent strength.

Further, a process for manufacturing laminated glass has been recently proposed, which does not need the above-mentioned high temperature and high pressure environment. As the process for manufacturing such laminated glass, there has been known, e.g. a process wherein two upper and lower substrates, which have a curable resin composition interposed therebetween, are disposed so as to face each other in a vertical direction, and the curable resin composition is cured by, e.g. the application of an ultraviolet ray or heat with the both substrates being laminated so as to be brought into close contact with each other.

Patent Document 1 discloses a device wherein a laminated member, which is composed of two upper and lower substrates with an adhesive interposed therebetween, is pressed so as to have a certain gap therebetween, and the adhesive is cured by the application of an ultraviolet ray to manufacture a liquid crystal panel. In this device for manufacturing a liquid crystal panel, a pressing plate, which sucks and holds the upper substrate in the device, has an outer periphery in a horizontal direction surrounded and supported by flexible members, each of which is composed of a thin metal plate made of, e.g. stainless steel and is elastically deformable, while the flexible members are elastically deformed and the pressing plate is moved downward (descended) in micrometers to press the entire upper substrate by supplying a fluid into a closed space defined at an position above the pressing plate and the flexible members.

### PRIOR ART

### PATENT DOCUMENT

Patent Document 1: JP-A-2001-209058

### DISCLOSURE OF THE INVENTION

### PROBLEMS TO BE SOLVED BY THE INVENTION

However, since the device for manufacturing a liquid crystal panel according to Patent Document 1 is configured to move downward (descend) the pressing plate in micrometers, this device has a problem in that it is impossible to employ the device for manufacturing laminated glass, which needs to be moved downward (descended) with a distance of, e.g. at least 0.1 mm. In other words, although the flexible members, which surround the pressing plate, are deformed and move downward (descend) the pressing plate in micrometers by applying a pressure to the fluid, the flexible members are gradually stiffened in a planar direction thereof, being deformed, and have an apparent stiffness increased so as to become difficult to be elastically deformed, with the result that the application of this device is limited to a case where the downward move (descending distance) is small.

The proposal where a substrate is entirely pressed by use of a fluid as disclosed in Patent Document 1 has the following problem, e.g. when a plurality of pressing plates are employed to hold a substrate having a relatively large area or to be adapted for various sizes of substrates. If a pressing plate that is disposed at an edge portion of a substrate is brought into biased contact with the substrate so as to face only one portion thereof to the substrate, the held substrate is liable to come off since a portion of the pressing plate that does not face to the substrate greatly inclines, moving downward, to serve to push the substrate downward.

Further, for this reason, it has been difficult to employ the device for the other substrates than a substrate having a certain size. Although there is an option to configure the device such that the pressing plates are respectively supplied with a fluid, there is another problem that the provision of pipes, controlling members and so on required for such arrangement makes the structure of the device complicated and increases equipment cost. It has been found that when parts spirally deformable in a downward direction, such as torsion springs or coil springs, are employed in place of the above-mentioned flexible members, the holding portions of the flexible members have a length in a vertical direction extended, increasing the number of parts and making it impossible to make the device compact.

On the other hand, in the case of manufacturing laminated glass, it is demanded that paired facing substrates are bonded each other with their relative positions in a planar direction being precisely matched.

The present invention has been proposed in consideration of such circumstances. It is an object of the present invention to provide a device for holding a substrate, a process for holding a substrate, and a process for manufacturing laminated glass, which are capable of employing a simple and compact structure to determine the position of a substrate to be held with good accuracy, to ensure a force enough to attract a substrate and to prevent a substrate from coming off.

### MEANS TO ACCOMPLISH THE OBJECT

With respect to the above-mentioned problem, the inventor has found that when leaf springs (strip-shaped elastic members), each of which is composed of a strip-shaped member having an elasticity and having a flexible or bendable portion, are employed in place of plate-shaped members (flexible members) as disclosed in Patent Document 1, the leaf springs elastically deform in a direction perpendicular to the plane thereof (an out-of-plane direction), perform a function of curbing a deformation with a high stiffness in the other in-plane directions and a torsional direction and realize a simple structure with a small number of parts and with a minimized space.

Specifically, the present invention provides the following solutions in order to attain the above-mentioned object.

The present invention provides a device for holding a substrate, which is adapted to substantially horizontally hold a substrate and vertically move the substrate, including a support; at least one substrate attraction member supported by the support and configured to attract the substrate; and a plurality of strip-shaped elastic members, which couple an outer peripheral portion of the at least one substrate attraction member to regions of the support apart from the outer peripheral portion of the at least one substrate attraction member in a horizontal direction; wherein each of the strip-shaped elastic members includes a deformable portion, which is formed as a strip-shaped member disposed between one end portion for coupling to the at least one substrate attraction member and the other end portion for coupling to the support and having a wide width in a horizontal direction and a thin thickness in a vertical direction, and which allows the at least one substrate attraction member to relatively move closer to and apart from the support in the vertical direction and is deformable in the horizontal direction.

The present invention also provides a process for holding a substrate, which is adapted to substantially horizontally hold a substrate and vertically move the substrate, including providing a support; at least one substrate attraction member supported by the support and configured to attract the substrate; and a plurality of strip-shaped elastic members, which couple an outer peripheral portion of the at least one substrate attraction member to regions of the support apart from the outer peripheral portion of the at least one substrate attraction member in a horizontal direction, each of the strip-shaped elastic members including a deformable portion, which is formed as a strip-shaped member disposed between one end portion for coupling to the at least one substrate attraction member and the other end portion for coupling to the support and having a wide width in a horizontal direction and a thin thickness in a vertical direction, and which allows the substrate attraction member to relatively move closer to and apart from the support in the vertical direction and is deformable in the horizontal direction; attracting the at least one substrate by the at least one substrate attraction member by descending the support to relatively bring the at least one substrate attraction member closer to the support such that the plurality of strip-shaped elastic members are compressed and are displaced in one direction intersecting a direction for the at least one substrate attraction member and the support to be relatively brought closer to each other; and holding the substrate by the at least one substrate attraction member by ascending the support to bring the at least one substrate attraction member away from the support by making use of a weight of the substrate such that the plurality of strip-shaped elastic members are stretched and are displaced in a direction opposite to the one direction intersecting a direction for the at least one substrate attraction member and the support to be relatively brought away from each other.

In accordance with the device for holding a substrate and the process for holding a substrate, each of which the present invention is applied to, the plurality of strip-shaped elastic members, which couple the at least one substrate attraction member and the support so as to relatively move in a vertical direction for the substrate attraction member and the support to relatively move closer to and apart from each other, are disposed between the at least one substrate attraction member for attracting and holding a base member, and the support. More specifically, each of the strip-shaped elastic members includes a deformable portion, which is formed as a strip-shaped member disposed between one end portion for coupling to the at least one substrate attraction member and the other end portion for coupling to the support and having a wide width in the horizontal direction and a thin thickness in the vertical direction, and which allows the at least one substrate attraction member to relatively move closer to and apart from the support in the vertical direction and is deformable in the horizontal direction. Thus, the at least one substrate attracting member and the support are allowed to relatively move each other in the vertical direction to be brought closer to and apart from each other, the at least one substrate attraction member and the support are both restricted from relatively moving in the horizontal direction by a section stiffness of the strip-shaped elastic members to deformation in the horizontal direction, which is greater than a section stiffness of the strip-shaped elastic members to deformation in the vertical direction. On the other hand, the deformable portion of each of the strip-shaped elastic members is deformed in the horizontal direction to increase apparent stiffness to deformation in the vertical direction so as to prevent the deformation in the vertical direction from being restrained when the at least one substrate attraction member and the support are largely apart from each other in the vertical direction. As described above, the at least one substrate attraction member can cope with large deformation in the vertical direction by such a simple and compact structure. It is possible to sufficiently ensure the positional accuracy of a substrate since the attracted and held substrate is restricted from moving with respect to the support in the horizontal direction.

For example, even if a substrate has an insufficient flatness or inclines when the at least one substrate attraction member attracts the substrate, the strip-shaped elastic members are deformed to bring the at least one substrate attraction member in close contact with the substrate so as to follow the profile of the substrate such that the at least one substrate attraction member can ensure sufficient close contact with the substrate so as to strongly attract the substrate since the at least one substrate attraction member is supported by the support through the strip-shaped elastic members. Thus, it is possible to prevent an attracted and held substrate from coming off from the at least one substrate attraction member. The device for holding a substrate and the process for holding a substrate are applicable to a wide variety of purposes since a substrate held by the at least one substrate attraction member can be moved in a relatively wide range in the direction for the substrate attraction member to relatively move closer to and apart from the support. In particular, the device for holding a substrate and the process for holding a substrate are also applicable to, e.g. a case where a substrate has such a large size to be likely to warp when being held, or a case where a substrate itself originally has a warp.

In the device for holding a substrate according to the present invention, it is preferred that each of the strip-shaped elastic members be configured to bend or curve so as to have a greater length than a linear distance between the one end portion and the other end portion and to detour with respect to a straight line lying at the linear distance.

When the device for holding a substrate according to the present invention is configured such that each of the strip-shaped elastic members has an extending portion between the one end portion coupled to the at least one substrate attraction member and the other end portion coupled to the support and that the extending portion is longer than the liner distance between both end portions, each of the strip-shaped elastic members serves as a leaf spring configured to be bent or curved so as to detour with a straight line lying at the linear distance and to couple between both end portions; with the result that the at least one substrate attraction member and the support are allowed to relatively move each other with good accuracy in the vertical direction to be brought closer to and away from each other while the at least one substrate attraction member and the support are further restricted from relatively moving each other in the other directions than the direction to be brought closer to and away from each other.

In the device for holding a substrate according to the present invention, it is preferred that each of the strip-shaped elastic members have a smaller displacement between the one end portion and the other end portion in the horizontal direction than a relative displacement in the vertical direction when the at least one substrate attraction member is relatively moved with respect to the support in the vertical direction so as to be brought closer to or apart from the support.

When the device for holding a substrate according to the present invention is configured such that each of the strip-shaped elastic members has such a smaller displacement between the one end portion and the other end portion in the horizontal direction than a relative displacement in the vertical direction, the at least one substrate attraction member and the support are allowed to relatively move each other with good accuracy in the vertical direction to be brought closer to and away from each other while the at least one substrate attraction member and the support are further restricted from relatively moving each other in the other directions than the direction to be brought closer to and away from each other.

In the device for holding a substrate according to the present invention, it is preferred that each of the strip-shaped elastic members have a portion on a side of the one end portion and a portion on a side of the other end portion configured to be substantially axisymmetrical in a plane extending orthogonally to the vertical direction and that the one end portion and the other end portion are disposed so as to be close to and face each other.

When the device for holding a substrate according to the present invention is configured such that each of the strip-shaped elastic members has a portion on a side of the one end portion and a portion on a side of the other end portion configured to be substantially axisymmetrical to each other, the stiffness of the portion on the side of one end portion and the stiffness of the portion on the side of the other end portion are set at substantially the same level. When the one end portion and the other end portion of each of the strip-shaped elastic members are disposed so as to be close to and face each other, the at least one substrate attraction member and the support are allowed to relatively move each other with better precision and in a wide range. In each of the strip-shaped elastic members, the relative displacement between the one end portion for coupling with its corresponding substrate attraction member and the other end portion for coupling with the support in the other directions than the direction to bring closer to or apart from each other is more restricted by a decrease in the degree of freedom of both end portions.

In the device for holding a substrate according to the present invention, each of the strip-shaped elastic members may be formed in a substantially annular shape, a substantially U-character shape, a substantially V-character shape, a substantially C-character shape or a substantially Ω-character shape in the plane extending orthogonally to the vertical direction.

In the device for holding a substrate according to the present invention, each of the strip-shaped elastic members may formed in a substantially annular shape to be bent in an L-character shape in a plane orthogonal to the vertical direction, the at least one substrate attraction member may have corners on an outer periphery, and each of the strip-shaped elastic members may have a bent portion of an inner annular portion coupled to an outer peripheral corner of the at least one substrate attraction member and have a bent portion of an outer annular portion coupled to the support.

In the device for holding a substrate according to the present invention, it is preferred that the support have at least three regions with respect to each substrate attraction member, each of the regions containing the other end portion of each of a strip-shaped elastic member.

When the device for holding a substrate according to the present invention is configured such that each of the strip-shaped elastic members further restrains the at least one substrate attraction member from revolving with respect to the support, the relative displacement between the one end portion for coupling with its corresponding substrate attraction member and the other end portion for coupling with the support in each of the strip-shaped elastic members is more restricted in the other directions than the vertical direction.

In the device for holding a substrate according to the present invention, a combination of a substrate attraction member and strip-shaped elastic members may be disposed at plural positions on a lower side of the support.

In the device for holding a substrate according to the present invention, when a combination of a substrate attraction member and strip-shaped elastic members is disposed at plural positions, even if, e.g. a substrate having a relatively large area needs to be attracted and held, the substrate can be attracted by the plurality of substrate attraction members and be held with a sufficient holding force. When the plural substrate attraction members are configured to be supported by the strip-shaped elastic members such that the respective substrate attraction members are tiltable so as to be brought into close contact with a substrate so as to follow the inclination of the substrate, it is possible to ensure the close contact between the respective substrate attraction members and the substrate in a sufficient way and to obtain a higher attraction force. Further, it is possible to deal with various sizes of substrates.

In the device for holding a substrate according to the present invention, the support may be formed so as to cover an upper side of the at least one substrate attraction member, the at least one substrate attraction member may have a stopper formed on an upper side so as to be elastically deformable, and the stopper may be configured to be capable of being brought into contact with the support.

When the device for holding a substrate according to the present invention is configured such that the at least one substrate attraction member has a stopper configured to be brought into contact with the support when attracting a substrate by the at least one substrate attraction member, the at least one substrate attraction member can be urged to be pressed against the substrate more strongly to be brought into close contact with the substrate. Thus, it is possible to reliably increased the attraction force and the holding force to the substrate by the at least one substrate attraction member.

The device for holding a substrate according to the present invention may be placed in a reduced-pressure atmosphere.

Since the device for holding a substrate according to the present invention has a simple structure that the strip-shaped elastic members are elastically deformable to bring the at least one substrate attraction member into close contact with a substrate, no special additional equipment is required, and the equipment cost can be decreased even if the device is placed in a reduced pressure atmosphere, such as vacuum. Since the structure is simple and compact with a small number of parts, the at least one substrate attraction member, the support and the strip-shaped elastic members can be formed so as to be housed in a relatively small space whereby the space required for a region in a reduced pressure atmosphere can be minimized. Thus, it is possible to save the period of time required for, e.g. vacuuming for forming a reduced pressure atmosphere, and to improve workability and productivity.

Even if a resin material is exposed to the atmosphere in an uncured state after interposing the resin material between a pair of substrates facing each other, e.g. in a vertical direction in a reduced pressure atmosphere so as to form a layered structure, it is possible to prevent the paired substrates from being relatively moved and shifted in a horizontal direction by a blast or the like at the time of exposure to the atmosphere since the at least one substrate attraction member with an upper substrate attracted thereon restricts the substrate from moving in the horizontal direction.

In the device for holding a substrate according to the present invention, the at least one substrate attraction member may be configured to attract a substrate by electrostatic attraction.

When the device for holding a substrate according to the present invention is configured to allow the at least one substrate attraction member to attract a substrate by electrostatic attraction, it is possible to carry out the attraction and the release of the substrate in a simple way and for a short period of time. Even if a plurality of substrates need to be successively and repeatedly attracted, it is possible to ensure a required attraction force in a stable manner. Thus, workability and productivity is improved.

The present invention also provides a process for interposing, in a layered structure, a curable resin material between a pair of substrates facing in a vertical direction so as to form a layered structure, followed by curing the resin material to manufacture laminated glass, comprising providing a support; at least one substrate attraction member supported by the support and configured to attract an upper substrate of the paired substrates; and a plurality of strip-shaped elastic members, which couple an outer peripheral portion of the at least one substrate attraction member to regions of the support apart from the outer peripheral portion of the at least one substrate attraction member in a horizontal direction, each of the strip-shaped elastic members including a deformable portion, which is formed as a strip-shaped member disposed between one end portion for coupling to the at least one substrate attraction member and the other end portion for coupling to the support and having a wide width in a horizontal direction and a thin thickness in a vertical direction, and which allows the at least one substrate attraction member to relatively move closer to and apart from the support in the vertical direction and is deformable in the horizontal direction; attracting the upper substrate by the at least one substrate attraction member by descending the support to relatively bring the at least one substrate attraction member closer to the support such that the plurality of strip-shaped elastic members are compressed and are displaced in one direction intersecting a direction for the at least one substrate attraction member and the support to be relatively brought closer to each other; and holding the upper substrate by the at least one substrate attraction member by ascending the support to bring the at least one substrate attraction member away from the support by making use of a weight of the upper substrate such that the plurality of strip-shaped elastic members are stretched and are displaced in a direction opposite to the one direction intersecting a direction for the at least one substrate attraction member and the support to be relatively brought away from each other; placing a lower substrate of the paired substrates so as to face the upper substrate under the upper substrate with the resin material being interposed between the upper and lower substrates, the resin material comprising a curable resin composition; descending the support such that the lower substrate is brought into close contact with the upper substrate held by the at least one substrate attraction member with the resin material being interposed between the upper and lower substrates; and curing the resin material.

In accordance with the process for manufacturing the laminated glass according to the present invention, when the support is first descended with an upper substrate being apart from and facing the at least one substrate attraction member under the at least one substrate attraction member, and the at least one substrate attraction member and the upper substrate are brought closer to each other to bring the at least one substrate attraction member into contact with an upper side of the upper substrate, followed by further descending the support, the strip-shaped elastic members are compressed in the vertical direction and are displaced in one direction intersecting a direction for the at least one substrate attraction member and the support to be relatively brought closer to each other, with the result that the at least one substrate attraction member is brought into close contact with the upper side of the upper substrate so as to follow the profile of the upper side. Thus, the attraction of the upper substrate by the at least one substrate attraction member is reliably carried out.

In other words, even if the upper side of the upper substrate has an insufficient flatness or inclines in the horizontal direction, the attraction can be reliably carried out since the at least one substrate attraction member is brought into close contact with the upper side of the upper substrate so as to follow the profile of the upper side.

When the at least one substrate attraction member attracts the upper substrate, followed by ascending the support, the at least one substrate attraction member is relatively away from the support by making use of the weight of the upper substrate, with the result that the strip-shaped elastic members are stretched in the vertical direction and the at least one substrate attraction member and the support are displaced in a direction opposite to the one direction intersecting a direction for the at least one substrate attraction member and the support to be relatively brought away from each other, and the upper substrate is lifted in the vertical direction and is held.

In other words, since each of the strip-shaped elastic members has a greater sectional stiffness with respect to displacement in the horizontal direction than a sectional stiffness with respect to displacement in the vertical direction, the relatively displacement of the at least one substrate attraction member and the support in the horizontal direction is restricted, with the result that it is possible to prevent an attracted upper substrate from moving in the other directions than the vertical direction whereby the positional accuracy of the upper substrate in the horizontal direction is sufficiently ensured.

Even when the support is descended to bring the upper substrate into close contact with the lower substrate with the curable resin material interposed therebetween, the relative positional accuracy of the upper substrate and the lower substrate in the horizontal direction can be sufficiently ensured since the upper substrate attracted and held by the at least one substrate attraction member is allowed to move only in the vertical direction.

Since the resin material is made of a curable resin composition, the process has more excellent workability and a better material yield in comparison with a case the resin material is a deposited resin film or the like as in the prior art.

The process for manufacturing laminated glass according to the present invention may attract the upper substrate by use of a plurality of combinations of a substrate attraction member and strip-shaped elastic members.

In the process for manufacturing laminated glass according to the present invention, when the upper substrate is attracted by use of a plurality of combinations of a substrate attraction member and strip-shaped elastic members, it is possible to ensure a sufficient attraction force by attracting the upper substrate by the plural substrate attraction members even if the upper substrate to be attracted has a relatively large area. When the plural substrate attraction members are configured to be supported by the strip-shaped elastic members such that the respective substrate attraction members are tiltable to be brought into close contact with an upper side of a substrate so as to follow the profile the upper side, the close contact between the respective substrate attraction members and the upper substrate can be sufficiently ensured, further increasing the attraction force. It is possible to cope with various sizes of upper substrates.

In the process for manufacturing laminated glass, the placing of a lower substrate of the paired substrates so as to face the upper substrate under the upper substrate may include surrounding an outer periphery of the resin material on the lower substrate by a sealing member and placing the lower substrate so as to face the upper substrate under the upper substrate; and the bringing of the lower substrate into close contact with the upper substrate may include bringing the paired substrates into close contact with each other with the resin material and the sealing member interposed therebetween in a reduced-pressure atmosphere; and the process may include increasing a degree of reduced-pressure of the reduced-pressure atmosphere to press-bond the paired substrates between the bringing of the lower substrate into close contact with the upper substrate and the curing of the resin material.

In the process for manufacturing laminated glass according to the present invention, when the outer periphery of the resin material is surrounded by a sealing member on the lower substrate, and when the paired substrates are brought into close contact with each other with the resin material and the sealing member interposed therebetween, the resin material is placed in a sealed state. Thus, the paired substrates are more strongly pressed against each other, and the resin material is spread between the paired substrates without voids by bringing the paired substrates into close contact with each other with the resin material and the sealing member interposed therebetween in a reduced pressure atmosphere, such as vacuum, followed by increasing the pressure of the reduced pressure atmosphere by exposure to the atmosphere for example. Thus, it is possible to simply fill the resin material in between the substrates with good accuracy.

### EFFECTS OF THE INVENTION

In accordance with the device for holding a substrate and a process for holding a substrate with the present invention applied thereto, it is possible to obtain a strong attraction force and to reliably prevent an attracted substrate from coming off during holding since the substrate attracting member attracts the substrate so as to be brought into close contact with the substrate to follow the inclination of an upper side of the substrate. Further, it is possible to sufficiently ensure the positional accuracy of a substrate since the movement of the substrate attracted and held by the substrate attracting member is limited to a movement in a direction to bring the substrate attracting member and the support closer to or away from each other. Furthermore, it is adaptable to a wide variety of applications since a substrate attracted and held by the substrate attracting member is relatively widely movable in such a direction to bring the substrate attracting member and the support closer to or away from each other.

In accordance with the process for manufacturing laminated glass with the present invention applied thereto, it is possible to obtain a strong attraction force and to prevent an attracted upper substrate from coming off since the substrate attracting member attracts the upper substrate so as to be brought into close contact with the substrate to follow the profile of the upper substrate. Further, it is possible to sufficiently ensure the relative positional accuracy between the upper substrate and a lower substrate in a horizontal direction since the upper substrate attracted and held by the substrate attracting member is movable only in a vertical direction.

### BRIEF DESCRIPTION OF THE DRAWINGS

Fig. 1 is a cross-sectional side view showing a schematic structure of the device for holding a substrate according to an embodiment of the present invention;
Fig. 2 is a schematic plan view seen from line A-A of Fig. 1;
Figs. 3(a) and (b) are a plan view and a side view showing a portion indicated by a circle C in Fig. 2 in enlargement;
Fig. 4 is a cross-sectional side view showing a schematic structure of a vacuum chamber where the device for holding a substrate according to the embodiment is placed;
Figs. 5(a) and (b) are cross-sectional side views explaining how to attract a substrate in the device for holding a substrate according to the embodiment;
Figs. 6(a) and (b) are cross-sectional side views explaining how to hold a substrate in the device for holding a substrate according to the embodiment;
Fig. 7 is a schematic cross-sectional side view explaining relative positions of a plurality of electrostatic chucks and an upper substrate in the device for holding a substrate according to the embodiment;
Fig. 8 is a schematic plan view seen from line D-D of Fig. 7;
Figs. 9(a) and (b) are schematic plan views showing other examples of the relative positions of the plurality of electrostatic chucks and the upper substrate in the device for holding a substrate according to the embodiment;
Figs. 10(a) and (b) are a plan view and a side view showing a portion indicated by a circle E in Fig. 9(a) in enlargement;
Fig. 11 is a schematic cross-sectional side view explaining how to employ the plurality of electrostatic chucks to hold an upper substrate in the device for holding a substrate according to the embodiment;
Fig. 12 is a schematic cross-sectional side view explaining how to employ the plurality of electrostatic chucks to hold the upper substrate in the device for holding a substrate according to the embodiment;
Fig. 13 is a schematic cross-sectional side view explaining how to employ the plurality of electrostatic chucks to hold an upper substrate in the device for holding a substrate according to the embodiment;
Figs. 14(a) to (d) are schematic views explaining a procedure for manufacturing laminated glass by use of the device for holding a substrate according to the embodiment;
Figs. 15(a) and (b) are schematic plan views showing other examples of a leaf spring member of the device for holding a substrate according to the embodiment; and
Figs. 16(a) to (c) are schematic plan views showing other examples of a leaf spring member of the device for holding a substrate according to the embodiment.

### BEST MODE FOR CARRYING OUT THE INVENTION

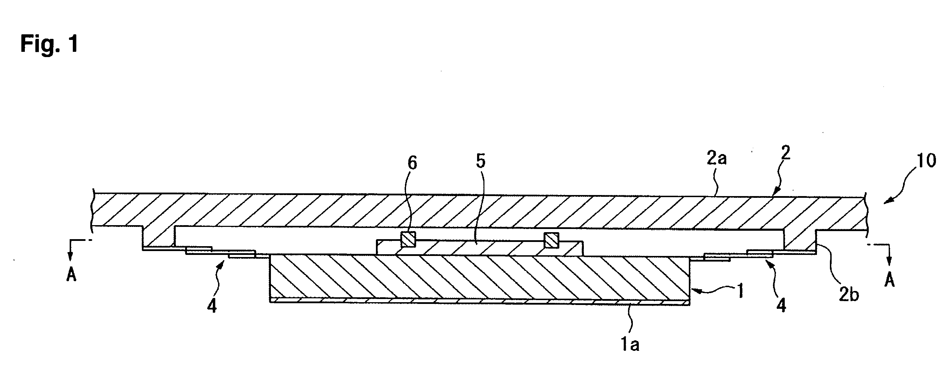

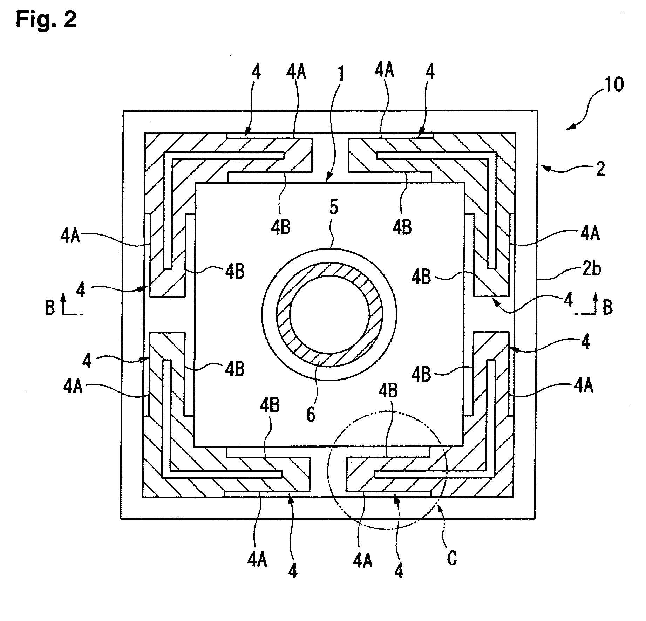

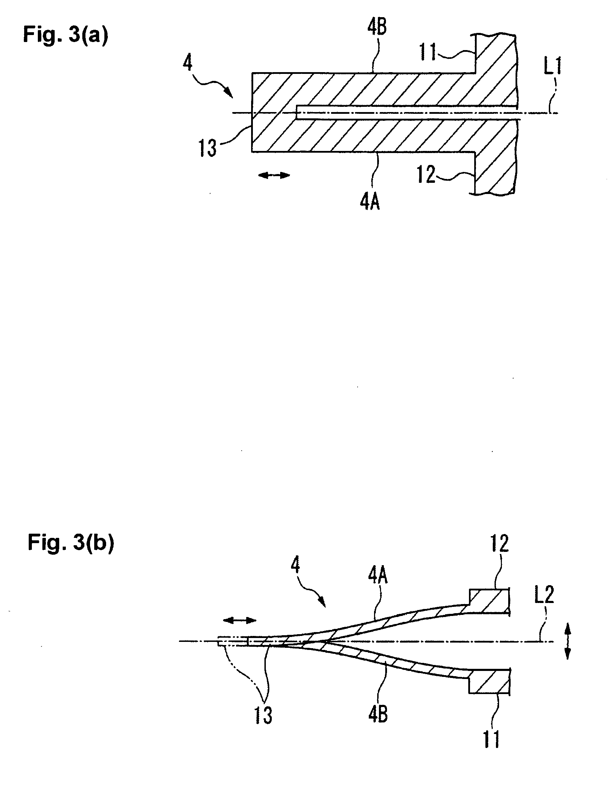

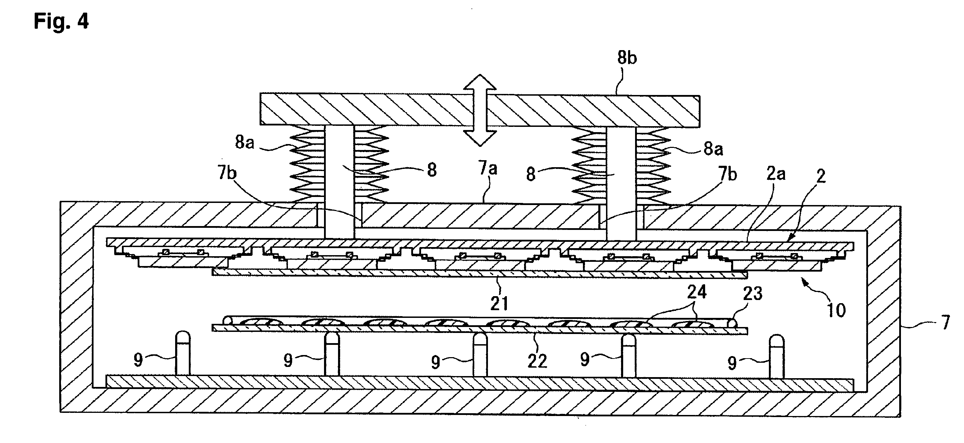

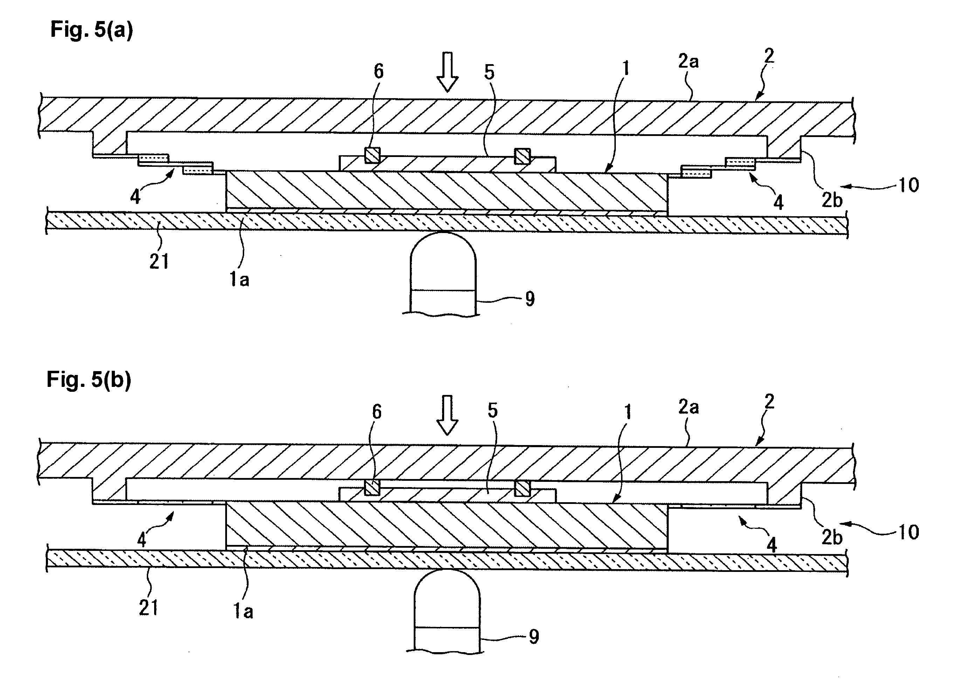

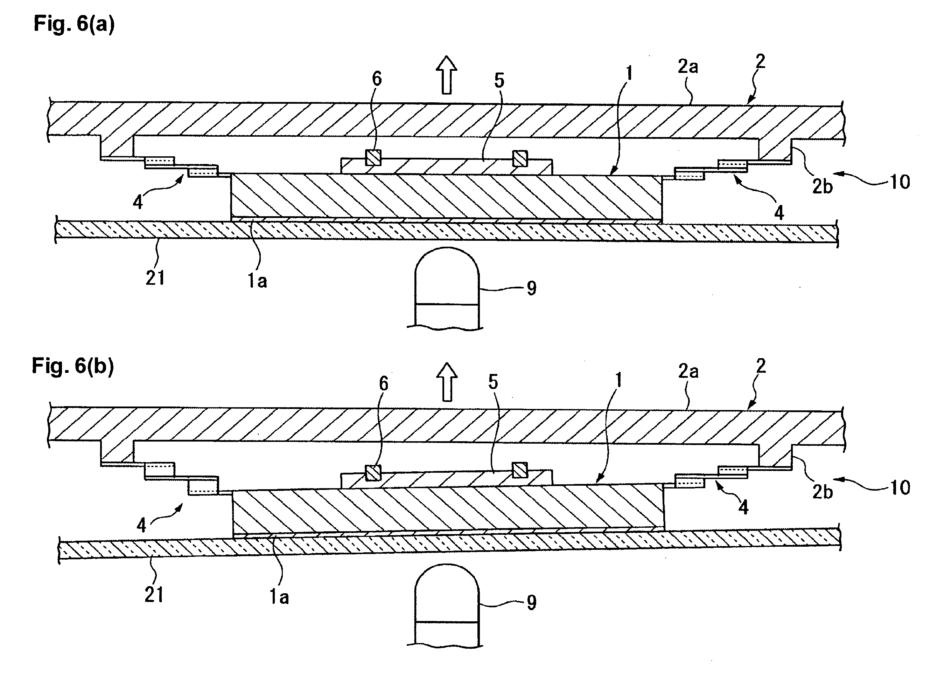

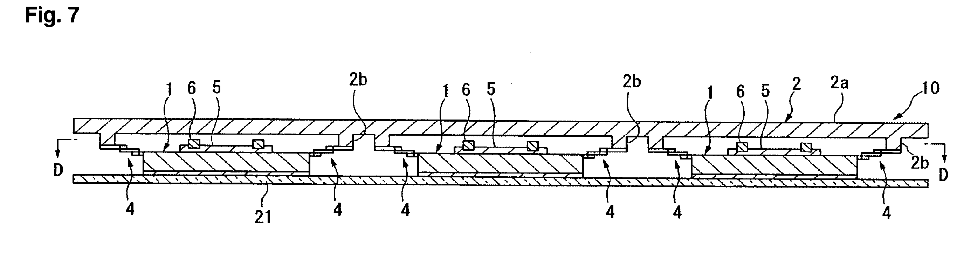

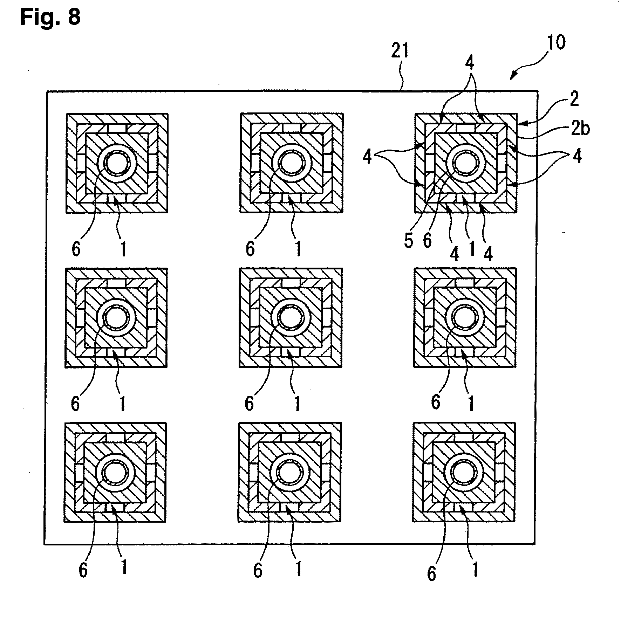

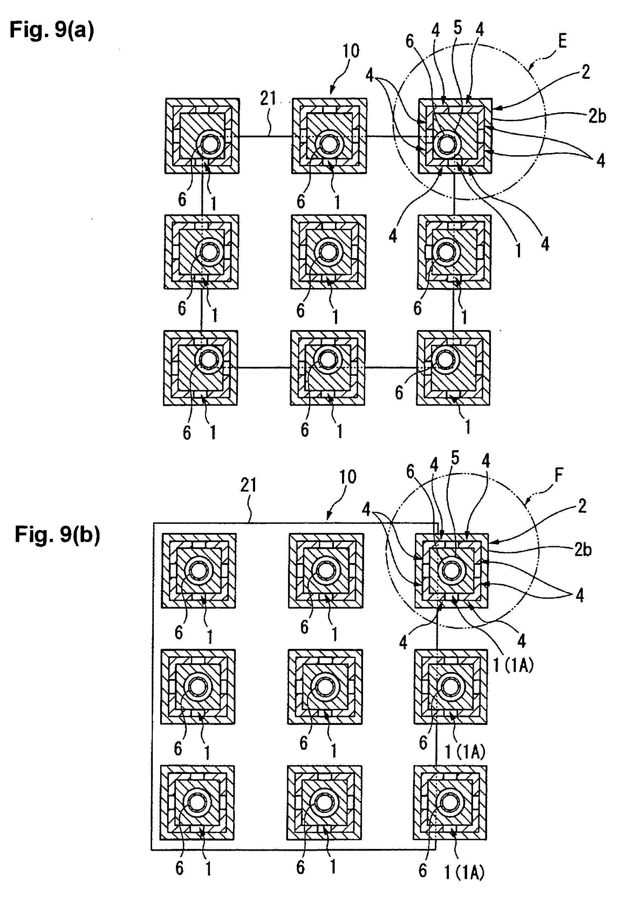

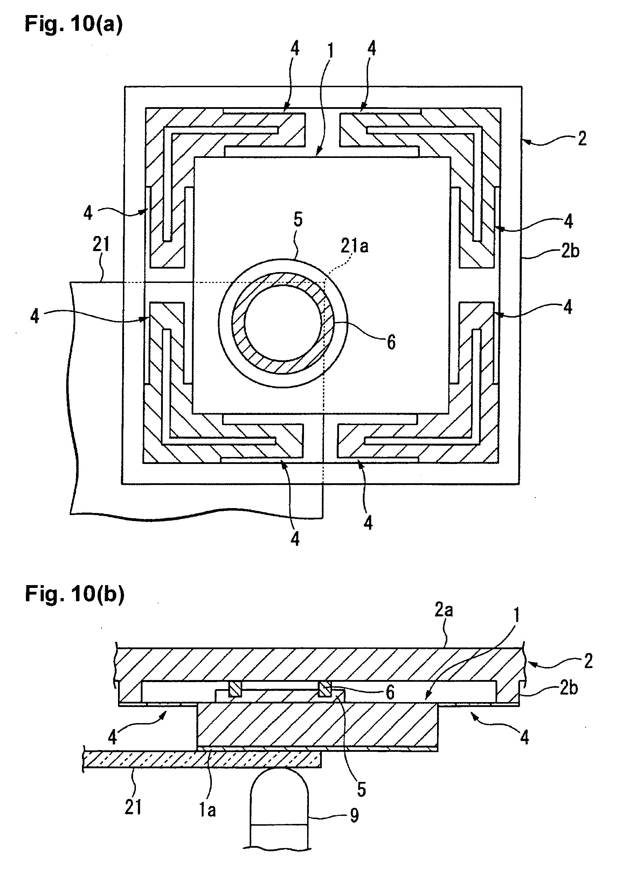

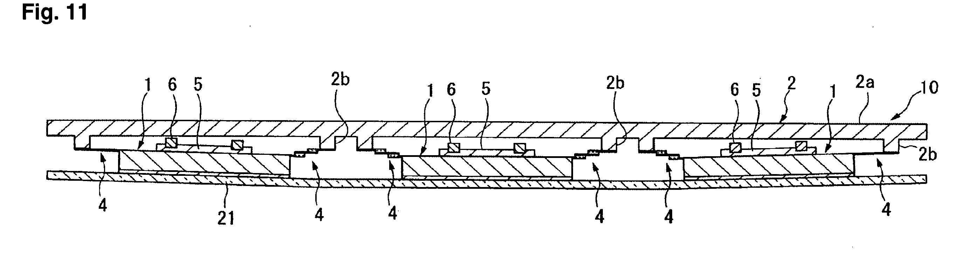

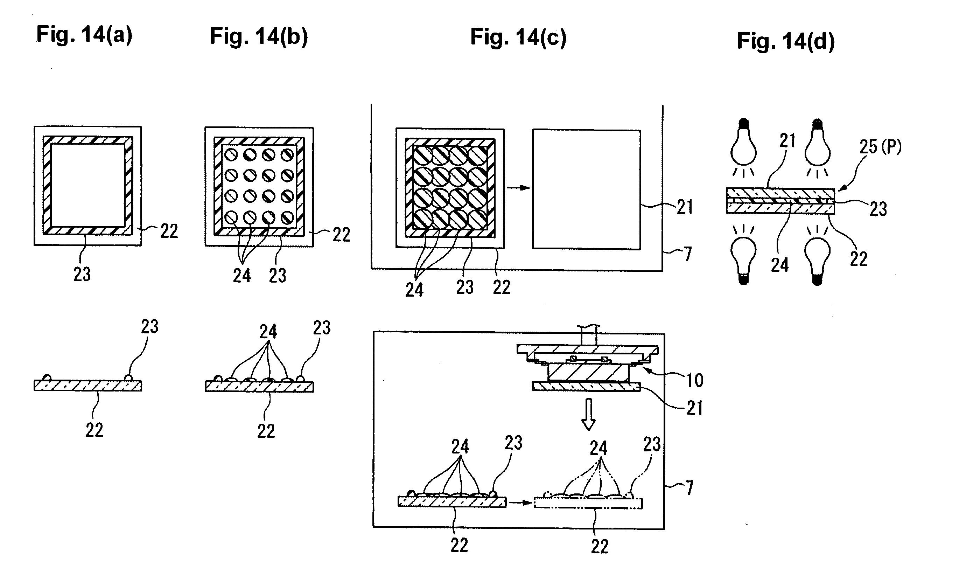

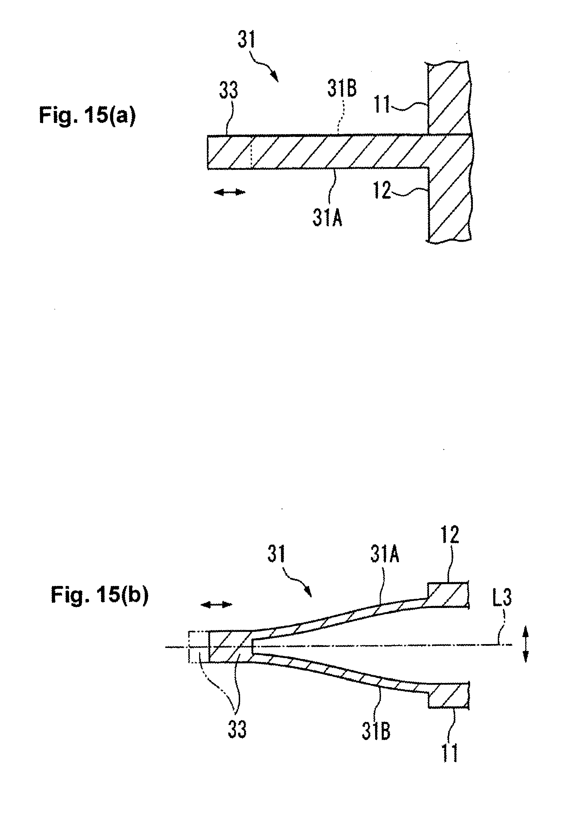

Fig. 1 is a cross-sectional side view showing a schematic structure of the device for holding a substrate according to an embodiment of the present invention; Fig. 2 is a schematic plan view seen from line A-A of Fig. 1; Figs. 3(a) and (b) are a plan view and a side view showing a portion indicated by a circle C in Fig. 2 in enlargement; Fig. 4 is a cross-sectional side view showing a schematic structure of a vacuum chamber where the device for holding a substrate according to the embodiment is placed; Figs. 5(a) and (b) are is cross-sectional side views explaining how to attract a substrate in the device for holding a substrate according to the embodiment; Figs. 6(a) and (b) are cross-sectional side views explaining how to hold a substrate in the device for holding a substrate according to the embodiment; Fig. 7 is a schematic cross-sectional side view explaining relative positions of a plurality of electrostatic chucks and an upper substrate in the device for holding a substrate according to the embodiment; Fig. 8 is a schematic plan view seen from line D-D of Fig. 7; Figs. 9(a) and (b) are schematic plan views showing other examples of the relative positions of the plurality of electrostatic chucks and the upper substrate in the device for holding a substrate according to the embodiment; Figs. 10(a) and (b) are a plan view and a side view showing a portion indicated by a circle E in Fig. 9(a) in enlargement; Figs. 11 to 13 are schematic cross-sectional side views explaining how to employ the plurality of electrostatic chucks to hold an upper substrate in the device for holding a substrate according to the embodiment; Figs. 14(a) to (d) are schematic views explaining a procedure for manufacturing laminated glass by use of the device for holding a substrate according to the embodiment; and Fig. 15(a) to Fig. 16(c) are schematic plan views showing other examples of a leaf spring member of the device for holding a substrate according to the embodiment. It should be noted that the cross-sectional side views of the device for holding a substrate in Figs. 1, 4 to 7 and 10 to 14 are cross-sectional side views seen from line B-B of Fig. 2.

As a pair of glass substrates (substrates) employed for manufacturing laminated glass in accordance with this embodiment, transparent glass substrates containing a composition of soda lime, which are normally employed as windows of a building, a vehicle and so on, may be employed. The paired substrates are rectangular plates, respectively and have the same outer dimensions in a planar direction. The outer dimensions may be variously set in a range of about 150 mm x about 300 mm to about 4,000 mm x about 3,000 mm for example, and the thickness of a single glass substrate forming laminated glass may be variously set in a range of about 2 mm to about 15 mm. The substrates have a mass density of about 2.5 g/cm³. For example, when a single glass substrate has dimensions of 4,000 mm x 3,000 mm and a thickness of 6 mm, the single glass substrate has a mass of about 180 kg.

Since the paired substrates have a resin material interposed therebetween, at least one of the paired substrates preferably has a side in contact with the resin material, treated with a coupling agent of a silane compound or a titanium compound. In other words, such a coupling agent is preliminarily applied to a side of a substrate and is bonded to the side by, e.g. heating. By employing a substrate with such a surface treatment applied thereto, the adhesiveness of a resin material to such a substrate is improved, increasing the mechanical strength of laminated glass.

As the resin material, a curable resin material having fluidity may be employed. Examples of such a curable resin material include a photosetting resin composition, which cures upon application of light, such as an ultraviolet ray, and a thermosetting resin composition, which cures upon heating. Such a curable resin material is preferably a photosetting resin composition that contains a polymerizable and curable compound, such as an acrylate compound or a methacrylate compound, and a photopolymerization initiator. Such a curable resin material is sealed in between the substrates and is cured after exposure to the atmosphere as described later.

The device for holding a substrate according to this embodiment is configured such that when laminated glass, which is composed of such a pair of substrates and such a resin material, is manufactured in a laminated structure, an upper substrate that is disposed at an upper position in the paired substrates is attracted and substrate suspended, and that the held upper substrate is descended toward the lower substrate so as to successively laminate the upper substrate, the resin material and the lower substrate.

As shown in Figs. 1 and 2, the device for holding a substrate 10 includes an electrostatic chuck (substrate attracting member) 1 for attracting and holding an upper side of an upper substrate (substrate), a support 2 disclosed above the electrostatic chuck 1 so as to cover the electrostatic chuck, and a plurality of strip-shaped leaf spring members (strip-shaped elastic members) 4, which are elastically deformable and are disposed between the electrostatic chuck 1 and the support 2 so as to couple the electrostatic chuck 1 and the support 2. The support 2 has such a combination of the electrostatic chuck 1 and these leaf spring members 4 disposed at a plurality of positions thereon.

Each electrostatic chuck 1 is formed in a substantially square plate-like shape or a substantially rectangular parallelepiped shape and has outer dimensions of about 150 mm x about 150 mm and a thickness of about 25 mm for example. The electrostatic chuck 1 has a lower side (side shown at a lower position in Fig. 1) formed with a dielectric film 1 a, which has an electrode pattern embedded therein and is composed of, e.g. a polyimide film. The electrostatic chuck 1 is configured to be electrically connected to an unshown high-voltage supply so as to attract an upper substrate with an electrostatic attracting force by applying a high voltage across the electrostatic chuck and the upper substrate facing thereto.

The support 2 includes a body portion 2a in a substantially rectangular plate-like shape or a substantially parallelepiped shape, and the body portion has projections 2b formed on a lower side thereof, each having a substantially square-shaped frame or a substantially rectangular frame.

Each of the leaf spring members 4 is made of a thin metal plate, a thin resin plate or the like having a thickness of from at least about 0.1 mm to at most about 1 mm for example and is disposed at a position close to each corner of each electrostatic chuck 1 as viewed in a plan view. Each leaf spring member 4 has a width of preferably from at least 5 mm to at most 100 mm and more preferably from at least 10 mm to at most 50 mm. By making use of these leaf spring members 4, it is possible not only to relatively move each electrostatic chuck 1 and the support 2 in a direction to bring close to or away from each other but also to restrain each electrostatic chuck and the support from relatively moving in the other directions than the direction to bring each electrostatic chuck and the support close to or away from each other since the width of each leaf spring member 4 is significantly greater than its thickness such that the flexural stiffness in the other directions than the direction to bring each electrostatic chuck and the support close to or away from each other and the torsional stiffness become significantly greater than the flexural stiffness in the direction to vertically bring each electrostatic chuck 1 and the support 2 close to or away from each other. This is clear from the fact that the flexural stiffness of each leaf spring member 4 is proportional to the cube of the length in a deformation direction in the section in question and is proportional to the length of a direction perpendicular to the deformation direction. As the measures to further increase the stiffness to a torsional force to incline the upper and lower sides of each leaf spring member 4, each leaf spring member 4 may have a thicker portion formed at each end in its width direction.

Each leaf spring member 4 includes deformable portions, each of which is composed of a pair of leaf spring elements 4A and 4B, and each of which bends so as to detour with respect to the straight line forming the shortest distance (linear distance) between the support 2 and its corresponding electrostatic chuck 1 as viewed in the plan view shown in Fig. 2. Each leaf spring member 4 has an upper side of an outer portion as viewed in the plan view, and the upper side is brought into contact with a lower side of its corresponding projection 2b of the support 2.

Specifically, each leaf spring member 4 is formed in a substantially annular shape to be bent in an L-character shape as a whole in a plane (horizontal plane) orthogonal to the vertical direction to bring its corresponding electrostatic chuck 1 and the support 2 close to or away from each other. Each leaf spring member 4 has an inner central portion, i.e. a bent portion of an inner annular portion (one end portion described later) coupled to an outer peripheral corner of its corresponding electrostatic chuck 1, and has an outer central portion, i.e. a bent portion of an outer annular portion (the other end portion described later) coupled to the support 2. Each projection 2b of the support 2 has four corners as viewed on the plan view, and each corner includes a region containing the outer central portion of an outer annular portion where its corresponding leaf spring member 4 is coupled to the projection 2b of the support 2.

The leaf spring element 4A of the leaf spring elements 4A and 4B of each leaf spring member 4 is disposed on an outer side as viewed in the plan view while the leaf spring element 4B is disposed on an inner side as viewed in the plan view. As shown in Figs. 3(a) and (b), each of the paired leaf spring elements 4A and 4B is formed as a substantially strip-shaped or substantially rectangular thin plate, the paired leaf spring elements 4A and 4B are disposed side by side and are close to each other so as to extend in substantially the same direction on the plan view, and the paired leaf spring elements have their first end portions in the extending direction (their lefthand ends in Figs. 3(a) and (b)) coupled by a connection portion 13 so as to form an integral structure. As described above, each leaf spring member 4 may be formed in a substantially annular shape, a substantially U-character shape, a substantially V-character shape, a substantially C-character shape or a substantially Ω-character shape as viewed in a plan view.

Each leaf spring element 4B has a second end portion (righthand end portion in Figs. 3(a) and (b)) in the extending direction (the one end portion) 11 coupled to its electrostatic chuck 1 while each leaf spring element 4A has a second end portion in the extending direction (the other end portion) 12 coupled to the corresponding projection 2b of the support 2. The second end portion 12 of each leaf spring element 4A and the second end portion 11 of each leaf spring element 4B are disposed so as to face and be close to each other as viewed in a plan view.

In each leaf spring member 4, its leaf spring element 4B on the side of the one end portion 11 and its leaf spring element 4A on the side of the other end portion 12 are formed so as to be substantially axisymmetrical with respect to an imaginary line L1 passing through the middle between the one end portion 11 and the other end portion 12 and extending in parallel with the extending direction of the leaf spring elements 4A and 4B.

As shown in Fig. 2, each electrostatic chuck 1 has a substantially circular plate-shaped stopper base 5 disposed at a substantially central portion of an upper side thereof so as to be detachable from the upper side, and the stopper base 5 has a substantially ring-shaped stopper 6 of elastically deformable silicone rubber, a coil spring or the like disposed on an upper side so as to upwardly project from the stopper base 5. The stopper 6 has a sufficient elasticity, which may be set at about 50 Shore "A" hardness when the stopper is made of silicone rubber. As shown in Fig. 1, the upper side of the stopper 6 is apart from the lower side of the body portion 2a of the support 2.

As shown in Fig. 4, the device for holding a substrate 10 is placed so as to be ascendable/descendable in the vacuum chamber 7, which is formed in a box shape and is sealable. Specifically, the vacuum chamber 7 has a plurality of through holes 7b formed in an upper side 7a, and respective bar-shaped lifting shaft 8, which extend in the vertical direction, pass through the respective through holes 7b. These lifting shafts 8 have lower ends coupled to an upper side of the body portion 2a of the support 2 for the device for holding a substrate 10 and upper ends integrally coupled to a lifting frame 8b.

The respective lifting shafts 8 are housed in metal bellows 8a, respectively, each of which is formed in a substantially accordion shape or substantially cylindrical shape so as to be stretchable/retractable in the vertical direction. These metal bellows 8a have upper ends brought into airtight contact with the lifting frame 8b and lower ends brought into airtight contact with the upper side 7a such that the respective lifting shafts 8 pass through the respective through holes 7b in an airtight manner.

The lifting frame 8b is coupled to an unshown drive source for vertical movement so as to be movable in the vertical direction. When the lifting frame 8b is vertically moved, the device for holding a substrate 10 is moved in the vertical direction in the sealed vacuum chamber 7. The vacuum chamber 7 has a plurality of bar-shaped supporting pins 9 erected on a bottom so as to face the respective electrostatic chucks 1 placed above the bottom.

The vacuum chamber 7 includes a positioning device in order that a substrate placed on supporting pins 9 is positioned in a horizontal direction with good accuracy.

Outside the vacuum chamber 7, an unshown depressurizing device, such as a vacuum pump, is placed and is coupled to the vacuum chamber 7, such that the vacuum chamber 7 has a vacuum atmosphere (reduced-pressure atmosphere) realized therein by vacuuming. The vacuum chamber 7 is configured to be capable of exposing the evacuated inside to the atmosphere to return the inside to the atmospheric environment. The degree of reduced pressure is preferably from 0.1 to 1,000 Pa, more preferably from 1 to 100 Pa.

Now, a procedure for attracting and holding a substrate by use of the device for holding a substrate 10 will be described.

First, an upper substrate 21 of a pair of glass plates for laminated glass to be manufactured is put into the vacuum chamber 7, and the upper substrate 21 is placed and positioned on supporting pins 9 by use of the positioning device. Next, as shown in Fig. 5(a), the device for holding a substrate 10 is descended to bring the dielectric films 1 a of electrostatic chucks 1 in contact with the upper side of the upper substrate 21.

The device for holding a substrate 10 is further descended to elastically deform the leaf spring members 4 of the electrostatic chucks as described later and to bring the stopper 6 on the upper sides of the electrostatic chucks 1 closer to the lower side of the body portion 2a of the support 2, such that the upper sides of the stoppers 6 one finally brought into contact with the lower side of the body portion 2a as shown in Fig. 5(b).

When the stoppers 6 and the support 2 are relatively moved in the vertical direction with the stoppers 6 being brought into contact with the body portion 2a, the stoppers 6 is elastically deformed, strongly pressing the upper side of the upper substrate 21 to the dielectric films 1 a of the electrostatic chucks 1 under the urging force of elastic deformation. Next, by applying a high voltage across the electrostatic chucks 1 and the upper substrate 21 in this state, the electrostatic chucks 1 attract the upper substrate 21 by electrostatic attraction.

Since the distance between the dielectric films 1 a and the upper side of the upper substrate 21 that is attracted so as to be pressed together with the dielectric films as described above is, e.g. less than 1 µm, it is possible to ensure about a two times to four times stronger attracting force in comparison with a case where the distance between the dielectric films 1 a and the upper side of the upper substrate 21 is at least 10 µm when only the weight of the electrostatic chucks 1 is utilized to attract the upper substrate 21 without employing the urging force caused by elastic deformation of the stoppers 6 as in the conventional techniques.

After the upper substrate 21 has been attracted to the dielectric films 1 a of the electrostatic chucks 1, the device for holding a substrate 10 is ascended to suspend the upper substrate 21 in the vacuum chamber 7 as shown in Figs. 6(a) and (b). If the upper substrate 21 fails to have a sufficient flatness or is inclined with respect to a horizontal direction as shown in Fig. 6(b), the electrostatic chucks 2, which have been brought into contact with the upper substrate 21, deform their leaf spring members 4 to tilt so as to follow the inclination of the upper substrate 21, are ascended with the upper substrate 21 being brought into close contact with and attracted to the electrostatic chucks and suspend the upper substrate 21.

Next, the deformation movement of the leaf spring members 4 will be described.

Each leaf spring member 4 relatively moves the one end portion 11 of its leaf spring element 4B and the other end portion 12 of its leaf spring element 4A in the vertical direction as shown in Fig. 3(b) when the corresponding electrostatic chuck 1 is pressed against an upper substrate 21 as described above or when supporting the weight of the electrostatic chuck 1 or the upper substrate 21 as described above.

Specifically, as shown in Figs. 3(a) and (b), the leaf spring elements 4A and 4B are integrally connected at their one end portions (their lefthand ends in Figs. 3(a) and (b)) by the connection portion 13. By this arrangement, the connection portion 13 can move in an extending longitudinal direction (the right to left direction in Figs. 3(a) and (b)), although the connection portion is configured to restrain their relative movement since the leaf spring elements 4A and 4B have a high flexural stiffness and a high torsional stiffness in a horizontal plane thereof in a transverse direction (in the vertical direction in Fig. 3(a)). Thus, the support 2 and the electrostatic chuck 1, which are respectively coupled to the other end portions (righthand ends in Figs. 3(a) and (b)) of the leaf spring elements 4A and 4B, are both restrained from being relatively moved in the longitudinal direction and the transverse direction.

When a stress (external force) is applied to a leaf spring member 4 so as to bring the one end portion 11 and the other end portion 12 close to each other in the vertical direction as shown in Fig. 3(b), the connection portion 13 of the leaf spring elements 4A and 4B is displaced toward one side (one direction), and the leaf spring member 4 is compressed in the vertical direction to bring the one end portion 11 and the other end portion 12 close to each other in the vertical direction. On the other hand, when a stress is applied to the leaf spring member 4 so as to separate the one end portion 11 and the other end portion 12 in the vertical direction, the connection portion 13 of the leaf spring elements 4A and 4B is displaced toward the other side (the opposite direction to the one direction), and the leaf spring member 4 is stretched in the vertical direction to separate the one end portion 11 and the other end portion 12 in the vertical direction. As described above, the one end portion 11 and the other end portion 12 of each leaf spring member 4 are configured to be relatively moved only in the vertical direction.

Thus, each leaf spring member is deformable such that a portion of the leaf spring element 4B on the side of the one end portion 11 and a portion of the leaf spring element 4A on the side of the other end portion 12 are elastically deformable so as to have a substantially axisymmetrical pattern with respect to an imaginary line L2 passing through the connection portion 13 and extending in the horizontal direction as viewed from a lateral side of the leaf spring member. In other words, it is possible to restrict the movement of the one end portion 11 and the other end portion 12 in the other directions than the vertical direction by minimizing the difference in deformation in a lateral direction of the leaf spring element 4B and the leaf spring element 4A.

Next, the arrangement of the electrostatic chucks 1 facing an upper substrate 21 and the arrangement of the stoppers 6 will be described in reference to Figs. 7 to 10(b).

In the device for holding a substrate 10 according to this embodiment, the arrangement of the stopper 6 of the respective electrostatic chucks 1 facing an upper substrate 21 can be variously set according to the outer profile of the upper substrate 21 as viewed in a plan view in order to attract and hold various sizes of upper substrates 21.

The stopper 6 disposed on the upper side of each electrostatic chuck 1 is configured to be capable of changing its position within the outer profile of the electrostatic chuck 1. Specifically, pins and a plurality of holes to receive the pins are disposed on a lower side of the stopper base 5 supporting each stopper 6 and the side of the electrostatic chuck 1 facing the lower side. The arrangement of the stopper can be variously set by properly selecting hole to receive the pins.

When the electrostatic chucks 1 are all placed within the outer profile of an upper substrate 21 as viewed in a plan view as shown in Figs. 7 and 8, the respective stoppers 6 may be disposed at any positions, and each stopper may be disposed at the center of its corresponding electrostatic chuck 1 for example.

When at least one of the electrostatic chucks 1 is at least partially outside the outer profile of an upper substrate 21 as viewed in a plan view as shown in Figs. 9(a) and (b), the arrangement of the stopper 6 of the at least one electrostatic chuck 1 may be set as described below.

As shown in Fig. 9(a) and Figs. 10(a) and (b), the stopper 6 of the at least one electrostatic chuck 1 that is at least partially outside the outer profile of the upper substrate 21 is placed such that the stopper 6 faces the upper substrate 21 in its entire peripheral direction as viewed in a plan view. In other words, as shown in Figs. 10(a) and (b), the stopper 6 is placed so as to face the upper face plate 21 without interruption in its entire peripheral direction by disposing the stopper such that the corner 21 a of the upper substrate 21 that corresponds to the stopper protrudes slightly outward from the outer periphery of the stopper 6 in its radial direction.

The supporting pin 9 that corresponds to the stopper 6 is placed so as to have its axis aligned with the center of the stopper 6 as viewed in a plan view according to the set position of the stopper 6 as shown in Fig. 10(b).

In a case where even if the arrangement of a stopper 6 is modified, the stopper 6 cannot be placed so as to face the upper substrate 21 in its entire peripheral direction as shown in a portion indicated by F in Fig. 9(b), the stopper 6 may be placed outside the outer profile of the upper substrate 21 without being faced to the upper substrate 21.

Now, it will be described how to hold an upper substrate 21 by use of the plural electrostatic chucks 1 with the stoppers 6 being placed in conformity with the outer periphery of an upper substrate 21.

When the plural electrostatic chucks 1 are all placed within the outer profile of an upper substrate 21 as viewed in a plan view as shown in Fig. 8, all electrostatic chucks 1 are brought into close contact with the upper substrate 21 and attract the upper substrate 21 by electrostatic attraction, holding and suspending the upper substrate.

Even when the upper substrate 21 has an insufficient flatness, and the upper substrate 21 has different inclinations in its respective portions as shown in Fig. 11, the respective electrostatic chucks 1 are brought into contact with the upper substrate 21 and have the respective leaf spring members 4 elastically deformed and brought into close contact with the upper substrate 21 so as to follow the inclinations of the respective parts, attracting the upper substrate 21, and suspending the upper substrate.

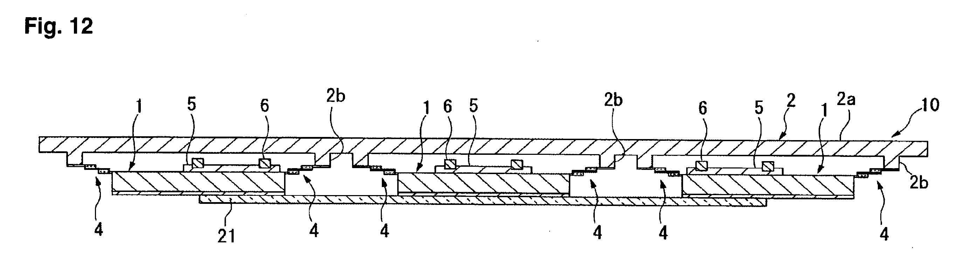

In a case where at least one of the electrostatic chucks 1 is partially placed outside the outer profile of an upper substrate 21 as viewed in a plan view as shown in Fig. 9(a), when the arrangement of the stopper 6 of the at least one electrostatic chuck 1 is changed such that the stopper 6 is placed so as to face the upper substrate 21 in its entire peripheral direction, all electrostatic chucks 1 are brought into close contact with the upper substrate 21 and attract the upper substrate 21 as shown in Fig. 12, suspending the upper substrate.

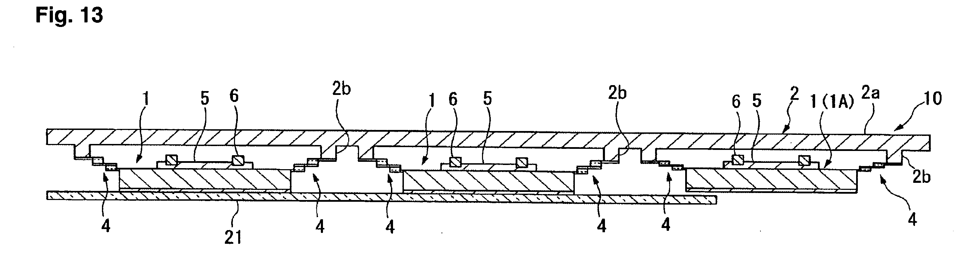

In a case where when at least one of the electrostatic chucks 1 is placed outside the outer profile of an upper substrate 21 as viewed in a plan view as shown in Fig. 9(b), and any arrangement of the stopper 6 of the at least one electrostatic chuck 1 cannot realize a situation that the stopper 6 faces the upper substrate 21 in its entire peripheral direction, the stopper 6 may be placed outside the outer profile of the upper substrate 21 so as not to face the upper substrate 21 as viewed in a plan view. In this case, as shown in Fig. 13, the at least one electrostatic chuck 1 A (the rightmost one in Fig. 13) that is partially outside the outer profile of the upper substrate does not attract the upper substrate 21 while the remaining electrostatic chucks 1 attract the upper substrate 21, suspending the upper substrate.

The at least one electrostatic chuck 1A has a lower side placed so as to be apart from the upper side of the upper substrate 21 with a slight gap since the remaining electrostatic chucks 1 that attract and hold the upper substrate 21 cause their leaf spring members 4 to be elastically deformed due to the weights of the upper substrate 21 and the remaining electrostatic chucks 1, being placed at a lower position than the at least one electrostatic chuck 1 A as shown in Fig. 13.

Next, a produce for manufacturing laminated glass by use of the device for holding a substrate 10 according to this embodiment will be described.

First, a sealing resin (sealing member) 23, which is composed of a high viscosity curable resin composition mixed with spacer particles, is applied in a substantially rectangular frame shape on a portion close to the outer periphery of the upper side of a lower substrate 21 of a pair of transparent substrates 21 and 22 as shown in Fig. 14(a).

Next, a resin material 24, which is composed of a curable resin composition having a low viscosity and curable upon application of an ultraviolet ray, is applied in a dot pattern at equal distances on a region of the lower substrate surrounded by the sealing resin 23 as shown in Fig. 14(b). The application of the resin material 24 is set so as to have a pitch of, e.g. about 30 mm, and the quantity of the applied resin material 24 is preliminary set such that the resin material 24 fills the gap surrounded and sealed by the sealing resin 23 and the paired substrates 21 and 22 when the substrates 21 and 22 are brought into close contact with each other as described later.

The sealing resin 23 and the resin material 24 may be supplied by a dispenser or a die coater for example.

On the other hand, the upper substrate 21 has been preliminarily suspended in the vacuum chamber 7 by use of the device for holding a substrate 10 as shown in Fig. 14(c) as described above. In this state, the lower substrate 21 with the sealing resin 23 and the resin material 24 applied the upper side thereof is introduced into under the upper substrate 21, and the lower substrate 22 is positioned to face the upper substrate by the positioning device.

Next, the vacuum chamber 7 is airtightly closed and is evacuated by use of the depressurizing device such that the inside of the vacuum chamber 7 is depressurized to form a vacuum environment.

Next, the paired substrates 21 and 22 are brought into close contact with each other in a layered structure with the sealing resin 23 and the resin material 24 interposed therebetween by descending the upper 21 by use of the device for holding a substrate 10. In this case, the upper substrate 21 is brought into close contact with the lower substrate 22 so as to be pressed against the lower substrate by making use of the weights of the upper substrate 21 and the electrostatic chucks 1 attracting the upper substrate.

Then, when the inside of the vacuum chamber 7 is returned to the original atmospheric environment by exposing the inside of the vacuum chamber 7 to the atmosphere to increase the pressure therein with the upper substrate 21 being attracted at its upper side by the electrostatic chucks 1, the paired substrates 21 and 22 are press-bonded together in the vertical direction to produce a laminated structure 25 by the difference between the inner pressure of a portion of the resin material 24 sealed by the paired substrates 21 and 22 and the sealing resin 23, and the external pressure. Even if a space without the resin material 24 being filled therein remains in the gap between the sealed substrates 21 and 22 before exposing the vacuum chamber to the atmosphere, the likelihood that such a space without the resin material 24 being filled therein remains in the gap between the sealed substrates 21 and 22 is reduced since the substrates 21 and 22 are pressurized due to exposure to the atmosphere to reduce the volume of such a remaining space. Likewise, even if bubbles exist in the resin material 24 before exposure to the atmosphere, such bubbles are likely to be distinguished by exposure to the atmosphere.

Finally, as shown in Fig. 14(d), ultraviolet rays are uniformly applied to the laminated member 25 from both sides of the upper substrate 21 and the lower substrate 22 by use of high-pressure mercury lamps or the like, whereby the sealing resin 23 and the resin material 24 are cured. Thus, laminated glass P is manufactured.

As described above, in the device for holding a substrate 10 according to this embodiment, the leaf spring members 4 are included between the support 2 and the electrostatic chucks 1 for attracting and holding the upper substrate 21 such that the leaf spring members couple the support 2 and the electrostatic chucks 1 so as to make the support and the electrostatic chucks relatively movable in the vertical direction to bring the support and the electrostatic chucks close to or apart from each other. When an electrostatic chuck 1 and the support 2 are relatively moved, the deformation portion composed of the paired leaf spring elements 4A and 4B coupled to the electrostatic chuck and formed in a bent shape so as to detour between the one end portion 11 and the other end portion 12 of the leaf spring members 4 affected by the relative movement is displaced in a direction intersecting the vertical direction, whereby it is possible not only to relatively move the electrostatic chuck 1 and the support 2 in the vertical direction but also to restrain the electrostatic chuck and the support from relatively moving in the other directions than the vertical direction. Since the upper substrate 21 attracted and held by the electrostatic chucks 1 is allowed to move only in the vertical direction as described above, the positional accuracy of the upper substrate 21 in the horizontal direction can be sufficiently ensured. In the present invention, the positional accuracy of a substrate having dimensions of 4,000 mm x 3,000 mm is preferably within ±0.5 mm, more preferably within ±0.1 mm in the horizontal direction.

For example, even if the upper side of an upper substrate 21 has an insufficient flatness or inclines in a horizontal direction when the upper substrate 21 is attracted by electrostatic chucks 1, the electrostatic chucks 1 can ensure sufficient close contact with the upper substrate 21 so as to strongly attract the upper substrate since the electrostatic chucks 1 are supported by the support 2 through the leaf spring members 4 such that the leaf spring members 4 are deformable to bring the electrostatic chucks 1 in close contact with the upper substrate 21 so as to follow the inclination of the upper side of the upper substrate.

Thus, the held upper substrate 21 is prevented from e.g. coming off from the electrostatic chucks 1. The device for holding a substrate is applicable to various kinds of applications because of being capable of vertically moving an upper substrate 21 held by electrostatic chucks 1 in a relatively wide range.

It is possible not only to carry out the relative vertical movement of the electrostatic chucks 1 and the support 2 with better precision and in a wide range but also to restrain the relative horizontal movement of the electrostatic chucks and the support since a portion of the leaf spring element 4B on the side of the one end portion 11 and a portion of the leaf spring element 4A on the side of the other end portion 12 at the deformable portion of a leaf spring member 4 are configured to be substantially axisymmetrical with respect to the imaginary line L1 such that the stiffness on the side of the one end portion 11 and the stiffness on the side of the other end portion 12 at the deformable portion are set at substantially the same level and since the one end portion 11 and the other end portion 12 of the leaf spring member 4 are disposed so as to be close to and face each other.

Since a plurality of combinations, each of which is composed of an electrostatic chuck 1 and leaf spring members 4, are disposed, it is possible to attract an upper substrate 21 with a sufficient holding force by plural electrostatic chucks 1 even if the upper substrate 21 to be attracted and held has a relatively large area for example. Since the electrostatic chucks 1 are supported by the leaf spring members 4 such that the respective electrostatic chucks are tiltable so as to be brought into close contact with an upper substrate 21 so as to follow the inclination of the upper side of the upper substrate, the respective electrostatic chucks 1 can ensure sufficient close contact with the upper substrate 21 so as to be strongly attract the upper substrate. The device for holding a substrate is applicable to a wide variety of various sizes of upper substrates 21.

For example, when each leaf spring member 4 has a spring constant set at 2 kgf/mm, it is possible to ensure a sufficient substrate holding force since a reduction in the attraction force is kept to about 20% even if the deviation between electrostatic chucks 1 in the vertical direction is 0.2 mm.

When an upper substrate 21 is attracted by electrostatic chucks 1, the stoppers 6 of the electrostatic chucks 1 can be brought into contact with the body portion 2a of the support 2 so as to elastically deform the stoppers 6, whereby the electrostatic chucks are urged to be pressed against the upper substrate 21 more strongly so as to be brought into close contact with the upper substrate. Thus, it is possible to more reliably increase the attraction force and the holding force to the upper substrate 21 by the electrostatic chucks 1.

Since the device for holding substrate 10 has such a simple structure that the leaf spring members 4 are deformable so as to bring the respective electrostatic chucks 1 into close contact with an upper substrate 21, it is not necessary to employ a complicated structure or control for independently controlling the vertical movement of the respective electrostatic chucks 1 by use of, e.g. a fluid pressurization system or the like as in the prior art. Even when the device for holding a substrate is placed in a reduced-pressure atmosphere as in this embodiment, the provision of special additional equipment is not needed, reducing equipment cost.

Since the device for holding a substrate has a small number of parts and a simple structure, it is possible to house the electrostatic chucks 1, the support 2 and the leaf spring members 4 in a space having a relatively small volume in the vertical direction, and it is possible to significantly reduce the space required as the region in a vacuum chamber 7 under a reduced-pressure atmosphere. Thus, it is possible to significantly save the time required for, e.g. vacuuming for creating such a reduced-pressure atmosphere, whereby workability and productivity are improved.

Even if the inside of a vacuum chamber 7 is exposed to the atmosphere with the sealing resin 23 and the sealing material 24 being in an uncured state after the sealing resin 23 and the sealing material 24 are interposed and laminated between a pair of substrates 21 and 22 vertically facing each other in a reduced pressure atmosphere, the paired substrates 21 and 22 can be prevented from being relatively moved and shifting by, e.g. a burst at the time of exposure to the atmosphere since the electrostatic chucks 1 attracting the upper substrate 21 restrict the movement of the upper substrate 21 in a horizontal direction.

Since an upper substrate 21 is attracted by electrostatic chucks by electrostatic attraction, it is possible to simply and rapidly the attraction and the release of the upper substrate 21 and to stably ensure a required attraction force even if a plurality of upper substrates 21 are successfully and repeatedly attracted. Thus, workability and productivity are improved.

Since each of the sealing resin 23 and the resin material 24 is made of a curable resin composition, it is possible to have excellent workability and good yield of the materials in comparison with a case where e.g. a deposited resin film is employed as the resin material 24 as in the prior art.

Since the reduced-pressure atmosphere is exposed to the atmosphere to increase the pressure in a vacuum chamber after a pair of substrates 21 and 22 are brought into close contact with each other in a layered structure with the sealing resin 23 and the resin material 24 being interposed therebetween under the reduced-pressure atmosphere, the pair of substrates 21 and 22 are more strongly press-bonded against each other through the laminated member 25, and the resin material 24 is spread between the pair of substrates 21 and 22 without voids. Thus, it is possible to expel air remaining in the resin material 24 and fill the resin material in between the paired substrates 21 and 22 in a simple may and with good accuracy.

It should be noted that the present invention is not limited to the above-mentioned embodiment. Various changes and modifications may be made in the present invention without departing from the sprit or scope of the invention.

For example, although the explanation of this embodiment has been made about a case where each leaf spring member 4 has a deformable portion formed between its one end portion 11 and its other end portion 12 so as to be composed of a pair of leaf spring elements 4A and 4B and to bend in a detour way, it is sufficient that each leaf spring member 4 has a deformable portion formed so as to bend or curve in a detour way. The present invention is not limited to the above-mentioned embodiment.

The examples shown in Figs. 15(a) to 16(c) are other examples of each of the leaf spring members 4. The leaf spring member 31 shown in Figs. 15(a) and (b) is composed of strip-shaped leaf spring elements 31 A and 31 B extending the same direction. The leaf spring elements 31 A and 31 B are configured so as to overlap as viewed in a plan view and to be close to and face each other in a vertical direction. In this example, the detour or the bend between both end portions of the leaf spring member 4 is located in the vertical direction, not in a horizontal direction. The leaf spring elements 31 A and 31 B are coupled at their one end portions in the extending direction (their lefthand ends in Figs. 15(a) and (b)) by a connection portion 33 so as to form an integral structure. The leaf spring element 31 B has its other end portion 11 in the extending direction (its righthand ends in Fig. 15) coupled to its corresponding electrostatic chuck 1, and the leaf spring element 31 A has its other end portion 12 in the extending direction coupled to its corresponding support 2.

When stress is applied to the leaf spring member 31 thus constructed such that the one end portion 11 and the other end portion 12 are brought closer to each other in the vertical direction, the connection portion 33 of the leaf spring elements 31 A and 31 B is displaced toward one direction, and the leaf spring member 31 is compressed in the vertical direction so as to bring the one end portion 11 and the other end portion 12 closer to each other in the vertical direction as shown in Fig. 15(b). When stress is applied to the leaf spring member 31 such that the one end portion 11 and the other end portion 12 are apart from each other in the vertical direction, the connection portion 33 of the leaf spring elements 31 A and 31 B is displaced toward the other direction, and the leaf spring member 31 is stretched in the vertical direction so as to cause the one end portion 11 and the other end portion 12 to be apart from each other in the vertical direction.

In other words, the one end portion 11 and the other end portion 12 of the leaf spring member 31 are allowed to relatively move only in the vertical direction and are restricted from relatively moving in the other directions than the vertical direction.

As shown in Fig. 15(b), the leaf spring member 31 is deformable such that a portion of the leaf spring element 31 B on the side of the one end 11 and a portion of the leaf spring element 31 A on the side of the other end portion 12 are elastically deformable so as to have a substantially axisymmetrical pattern with respect to an imaginary line L3 passing through the connection portion 33 and extending in the horizontal direction as viewed from a lateral side of the leaf spring member 31.

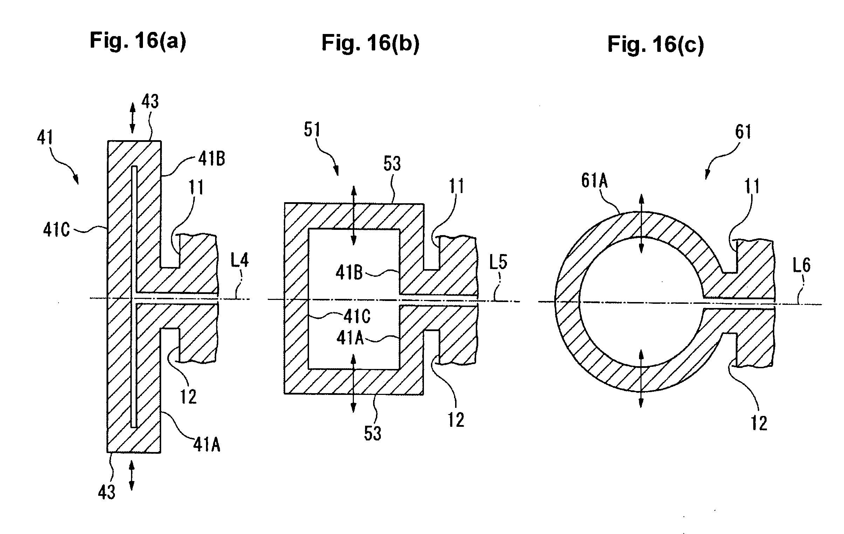

The leaf spring member 41 shown in Fig. 16(a) includes a deformable portion, which is composed of strip-shaped leaf spring elements 41 A and 41 B in a substantially L-character form and a strip-shaped leaf spring element 41 C in a substantially I-character form. The leaf spring elements 41 A and 41 B are disposed such that their short sides are brought close to and face each other as viewed in a plan view, and each of their short sides has one end portion in its extending direction (a lefthand end in Fig. 16(a)) coupled to a long side, which extends to be substantially orthogonal to its corresponding short side. On the other hand, the leaf spring element 41 B has the other end portion of its short side (a righthand end in Fig. 16(a)) serving as the one end portion 11 for coupling with a corresponding electrostatic chuck 1, and the leaf spring element 41A has the other end portion of its short side serving as the other end portion 12 for coupling with the support 2.

The respective long sides of the leaf spring elements 41A and 41B start with the respective one end portions of the respective short sides and extend in the opposite directions so as to be apart from each other. The leaf spring element 41 C is close to and face the long sides of the leaf spring elements 41 A and 41 B on one side. The leaf spring element 41 C has both ends coupled to respective outward-facing edges of the long sides of the leaf spring elements 41 A and 41 B by respective connection portions 43. In other words, the leaf spring member 41 is configured such that the leaf spring element 41 A, 41 B and 41 C are integrally coupled together by the two connection portions 43.

The one end portion 11 and the other end portion 12 in the leaf spring member 41 are configured so as to be substantially axisymmetrical with an imaginary line L4 passing through the middle between the one end portion 11 and the other end portion 12 and extending in parallel with a direction for the short sides to extend as viewed in a plan view.

When stress is applied to the leaf spring member 41 thus configured such that the one end portion 11 and the other end portion 12 are brought closer to each other in the vertical direction, the two connection portions 43 are displaced in a direction to be apart from each other as viewed in a plan view, and the leaf spring member 41 is compressed in the vertical direction to bring the one end portion 11 and the other end portion 12 closer to each other in the vertical direction. On the other hand, stress is applied to the leaf spring member 41 such that the one end portion 11 and the other end portion 12 are apart from each other in the vertical direction, the two connection portions 43 are displaced in a direction to be brought closer to each other as viewed in a plan view, and the leaf spring member 41 is stretched in the vertical direction to separate the one end portion 11 and the other end portion 12 in the vertical direction. Thus, the one end portion 11 and the other end portion 12 are allowed to relatively move only in the vertical direction, and are restricted from relatively moving in the other directions than the vertical direction.

Although not shown, the leaf spring member 41 is deformable such that portions of the leaf spring member 41 on the side of the one end portion 11 and on the side of the other end portion 12 are elastically deformable so as to have a substantially axisymmetrical pattern with respect to an imaginary line passing through the middle between the one end portion 11 and the other end portion 12 and extending in the horizontal direction as viewed from a lateral side of the leaf spring member 41.

The leaf spring member 51 shown in Fig. 16(b) includes respective connection portions 53, which couple respective leaf spring elements 41A and 41 B to a leaf spring element 41 C, and which extend in substantially parallel with a direction for short sides of the leaf spring elements 41 A and 41 B to extend.

A portion of the leaf spring element 51 on the side of the one end portion 11 and a portion of the leaf spring element 51 on the side of the other end portion 12 are configured to be substantially axisymmetrical with respect to an imaginary line L5 passing through the middle between the one end portion and the other end portion and extending in parallel with a direction for the short sides to extend as viewed in a plan view.

The leaf spring member 51 thus configured also allows the one end portion 11 and the other end portion 12 to relatively move only in the veridical direction and restrains the one end portion and the other end portion from relatively moving in other directions than the vertical direction.

Although not shown, the leaf spring member 51 is deformable such that portions of the leaf spring member 51 on the side of the one end 11 and on the side of the other end 12 are elastically deformable so as to have a substantially axisymmetrical pattern with respect to an imaginary line passing through the middle between the one end portion 11 and the other end portion 12 and extending in the horizontal direction as viewed from a lateral side of the leaf spring member 51.

The leaf spring member 61 shown in Fig. 16(c) is composed of a leaf spring element 61 A formed in a substantially C-character shape or a substantially Ω-character shape, both ends of the leaf spring element 61 A serving as one end portion 11 and the other end portion 12.

A portion of the leaf spring member 61 on the side of the one end portion 11 and a portion of the leaf spring member on the side of the other end portion 12 are configured to be substantially axisymmetrical with respect to an imaginary line L6 passing through the middle between the one end portion 11 and the other end portion 12 and extending in a direction intersecting the direction for the one end portion 11 and the other end portion 12 to face each other as viewed in a plan view.

The leaf spring member 61 thus configured also allows the one end portion 11 and the other end portion 12 to relatively move only in the veridical direction and restrains the one end portion and the other end portion from relatively moving in the other directions than the vertical direction. Although not shown, the leaf spring member 61 is deformable such that the portion of the leaf spring portion 61 on the side of the one end portion 11 and the portion of the leaf spring member on the side of the other end portion 12 are elastically deformable so as to have a substantially axisymmetrical pattern with respect to an imaginary line passing through the middle between the one end portion 1 and the other end portion 12 and extending the horizontal direction in the side view of Fig. 16(c) seen from the vertical direction.

Although the explanation of this embodiment has been made about a case where a plurality of combinations, each of which is composed of an electrostatic chuck 1 and leaf spring members 4, are disposed on the support 2, the present invention is not limited to this case, and only one combination of an electrostatic chuck 1 and leaf spring members 4 may be disposed.

Although the explanation of this embodiment has been made about a case where each of the projections 2b of the support 2 is formed as a substantially square-shaped frame or a substantially rectangular frame, and where regions, each of which contains a central portion of the outer annular portion (the other end portion) of a leaf spring member 4 for coupling to the projection 2b of the support 2, are placed at four locations of the four corners of the corresponding projection 2b, it is sufficient that such regions, each of which contains the other end portion of a leaf spring member 4 for coupling to the corresponding projection 2b of the support 2, can restrain the corresponding electrostatic chuck 1 from turning. For example, each of the projections 2b of the support 2 may be formed as a substantially triangular frame, and the regions, each of which contains the other end portion of a leaf spring member 4 for coupling to the corresponding projection 2b of the support 2, may be placed at three locations of the three corners of the projection 2b. When each of the projections 2b is formed as a substantially rectangular frame, the regions, each of which contains the other end portion of a leaf spring member 4 for coupling to the corresponding projection 2b of the support 2, may be placed at four locations of respective centers of the respective sides of the projection 2b.

The number of the leaf spring members and the leaf spring elements to be coupled to each of the projections 2b of the support 2 may be set according to the degree that the relative movement of the corresponding electrostatic chuck 1 and projection 2b in the horizontal direction should be restricted. For example, when the restriction in the horizontal direction needs to be severer, the number of the leaf spring elements is set at a larger value.

Although the explanation of this embodiment has been made about a case where an upper substrate 21 is attracted and held by making use of the electrostatic attraction of electrostatic chucks 1, the present invention is not limited to this case. Other attraction forces, such as adhesion, may be employed to attract or hold an upper substrate 21.

Although the explanation of this embodiment has been made about a case where the support 2 is formed in a substantially rectangular shape or a substantially parallelepiped shape and covers upper sides of the electrostatic chucks 1, it is sufficient that the support 2 supports the electrostatic chucks 1. For example, the support 2 may be formed in a substantially frame shape or a substantially ladder shape so as to part cover the upper sides of the electrostatic chucks 1.

Although the explanation of this embodiment has been made about a case where the stoppers 6 are disposed, the stoppers 6 may be eliminated, e.g. when the electrostatic chucks 1 have a sufficient attraction force to an upper substrate 21 without employing an urging force caused by the elastic deformation of the stoppers 6.

Although the explanation of this embodiment has been made about a case where the device for holding a substrate 10 is placed in a vacuum chamber 7, where the inside of the vacuum chamber 7 has a reduced pressure atmosphere, such as vacuum, and where a pair of substrates 21 and 22 are brought into close contact with each other in a layered structure with the sealing resin 23 and the resin material 24 interposed therebetween, the present invention is not limited to this case. The device for holding a substrate 10 may be placed in the atmospheric environment such that a pair of substrates 21 and 22 are brought into close contact each other in a layered structure with a sealing resin 23 and a resin material 24 interposed therebetween in the atmospheric environment.

Although the explanation of this embodiment has been made about a case where the one end portion 11 and the other end portion 12 of each leaf spring member 4 are disposed so as to be close to and face each other with respect to the imaginary line L1, the present invention is not limited to this case. The one end portion 11 and the other end portion 12 may need not to face each other.

Although the explanation of this embodiment has been made about a case where the leaf spring element 4B on the side of the one end portion and the leaf spring element 4A on the side of the other end portion 12 in the each leaf spring member 4 are disposed so as to be substantially axisymmetrical with the imaginary line L1, the present invention is not limited to this case.

### INDUSTRIAL APPLICABILITY

The device for holding a substrate and a process for holding a substrate, to which the present invention is applied, are useful when manufacturing laminated glass, a liquid crystal panel and the like.

The entire disclosure of Japanese Patent Application No. 2008-206124 filed on August 8, 2008 including specification, claims, drawings and summary is incorporated herein by reference in its entirety.

### EXPLANATION OF REFERENCE NUMERALS

- 1, 1A:: Electrostatic chuck (substrate attraction member)
- 2:: Support
- 4, 31, 41, 51, 61:: Leaf spring member (strip-shaped elastic member)
- 6:: Stopper
- 7:: Vacuum chamber
- 10:: Device for holding a substrate
- 11:: One end portion of leaf spring member
- 12:: Other end portion of leaf spring member
- 21:: Upper substrate (substrate)
- 22:: Lower substrate (substrate)
- 23:: Sealing resin (sealing member)
- 24:: Resin material
- P:: Laminated glass

## Claims

1. A device for holding a substrate, which is adapted to substantially horizontally hold a substrate and vertically move the substrate, comprising:
a support;
at least one substrate attraction member supported by the support and configured to attract the substrate; and
a plurality of strip-shaped elastic members, which couple an outer peripheral portion of the at least one substrate attraction member to regions of the support apart from the outer peripheral portion of the at least one substrate attraction member in a horizontal direction;
wherein each of the strip-shaped elastic members includes a deformable portion, which is formed as a strip-shaped member disposed between one end portion for coupling to the at least one substrate attraction member and the other end portion for coupling to the support and having a wide width in a horizontal direction and a thin thickness in a vertical direction, and which allows the at least one substrate attraction member to relatively move closer to and apart from the support in the vertical direction and is deformable in the horizontal direction.

2. The device according to Claim 1, wherein each of the strip-shaped elastic members is configured to bend or curve so as to have a greater length than a linear distance between the one end portion and the other end portion and to detour with a straight line lying at the linear distance.

3. The device according to Claim 1 or 2, wherein each of the strip-shaped elastic members has a smaller displacement between the one end portion and the other end portion in the horizontal direction than a relative displacement in the vertical direction when the at least one substrate attraction member is relatively moved with respect to the support in the vertical direction so as to be brought closer to or apart from the support.

4. The device according to any one of Claims 1 to 3, wherein each of the strip-shaped elastic members has a portion on a side of the one end portion and a portion on a side of the other end portion configured to be substantially axisymmetrical in a plane extending orthogonally to the vertical direction and that the one end portion and the other end portion are disposed so as to be close to and face each other.

5. The device according to Claim 4, wherein each of the strip-shaped elastic members is formed in a substantially annular shape, a substantially U-character shape, a substantially V-character shape, a substantially C-character shape or a substantially Ω-character shape in the plane extending orthogonally to the vertical direction.

6. The device according to any one of Claims 1 to 3, wherein each of the strip-shaped elastic members is formed in a substantially annular shape to be bent in an L-character shape in a plane orthogonal to the vertical direction, the at least one substrate attraction member has corners on an outer periphery, and each of the strip-shaped elastic members has a bent portion of an inner annular portion coupled to an outer peripheral corner of the at least one substrate attraction member and has a bent portion of an outer annular portion coupled to the support.

7. The device according to any one of Claims 1 to 6, wherein the support has at least three regions with respect to each substrate attraction member, each of the regions containing the other end portion of a strip-shaped elastic members.

8. The device according to any one of Claims 1 to 7, wherein a combination of a substrate attraction member and strip-shaped elastic members is disposed at plural positions on a lower side of the support.

9. The device according to any one of Claims 1 to 8, wherein the support is formed so as to cover an upper side of the at least one substrate attraction member;
the at least one substrate attraction member has a stopper formed on an upper side so as to be elastically deformable; and
the stopper is configured to be capable of being brought into contact with the support.

10. The device according to any one of Claims 1 to 9, which is placed in a reduced-pressure atmosphere.

11. The device according to any one of Claims 1 to 10, wherein the at least one substrate attraction member is configured to attract the substrate by electrostatic attraction.

12. A process for holding a substrate, which is adapted to substantially horizontally hold a substrate and vertically move the substrate, comprising:
providing a support; at least one substrate attraction member supported by the support and configured to attract the substrate; and a plurality of strip-shaped elastic members, which couple an outer peripheral portion of the at least one substrate attraction member to regions of the support apart from the outer peripheral portion of the at least one substrate attraction member in a horizontal direction, each of the strip-shaped elastic members including a deformable portion, which is formed as a strip-shaped member disposed between one end portion for coupling to the at least one substrate attraction member and the other end portion for coupling to the support and having a wide width in a horizontal direction and a thin thickness in a vertical direction, and which allows the at least one substrate attraction member to relatively move closer to and apart from the support in the vertical direction and is deformable in the horizontal direction;
attracting the substrate by the at least one substrate attraction member by descending the support to relatively bring the at least one substrate attraction member closer to the support such that the plurality of strip-shaped elastic members are compressed and are displaced in one direction intersecting a direction for the at least one substrate attraction member and the support to be relatively brought closer to each other; and
holding the substrate by the at least one substrate attraction member by ascending the support to bring the at least one substrate attraction member away from the support by making use a weight of the substrate such that the plurality of strip-shaped elastic members are stretched and are displaced in a direction opposite to the one direction intersecting a direction for the at least one substrate attraction member and the support to be relatively brought away from each other.

13. A process for manufacturing laminated glass, which comprises interposing a curable resin material between a pair of substrates facing in a vertical direction, followed by curing the resin material, comprising:
providing a support; at least one substrate attraction member supported by the support and configured to attract an upper substrate of the paired substrates; and a plurality of strip-shaped elastic members, which couple an outer peripheral portion of the at least one substrate attraction member to regions of the support apart from the outer peripheral portion of the at least one substrate attraction member in a horizontal direction, each of the strip-shaped elastic members including a deformable portion, which is formed as a strip-shaped member disposed between one end portion for coupling to the at least one substrate attraction member and the other end portion for coupling to the support and having a wide width in a horizontal direction and a thin thickness in a vertical direction, and which allows the at least one substrate attraction member to relatively move closer to and apart from the support in the vertical direction and is deformable in the horizontal direction;
attracting the upper substrate by the at least one substrate attraction member by descending the support to relatively bring the at least one substrate attraction member closer to the support such that the plurality of strip-shaped elastic members are compressed and are displaced in one direction intersecting a direction for the at least one substrate attraction member and the support to be relatively brought closer to each other; and
holding the upper substrate by the at least one substrate attraction member by ascending the support to bring the at least one substrate attraction member away from the support by making use a weight of the upper substrate such that the plurality of strip-shaped elastic members are stretched and are displaced in a direction opposite to the one direction intersecting a direction for the at least one substrate attraction member and the support to be relatively brought away from each other;
placing a lower substrate of the paired substrates so as to face the upper substrate under the upper substrate with the resin material being interposed between the upper and lower substrates, the resin material comprising a curable resin composition;
descending the support such that the lower substrate is brought into close contact with the upper substrate held by the at least one substrate attraction member with the resin material being interposed between the upper and lower substrates; and
curing the resin material.

14. The process according to Claim 13, further comprising attracting the upper substrate by use of a plurality of combinations of a substrate attraction member and strip-shaped elastic members.

15. The process according to Claim 13 or 14, wherein the placing of the lower substrate so as to face the upper substrate includes surrounding an outer periphery of the resin material on the lower substrate by a sealing member and placing the lower substrate so as to face the upper substrate under the upper substrate;
the bringing of the lower substrate into close contact with the upper substrate includes bringing the paired substrates into close contact with each other with the resin material and the sealing member interposed therebetween in a reduced-pressure atmosphere; and
between the bringing of the lower substrate into close contact with the upper substrate and the curing of the resin material, increasing a degree of reduced-pressure of the reduced-pressure atmosphere to press-bond the paired substrates.
